# EUROPÄISCHE PATENTANMELDUNG

(11) **EP 2 190 277 A1**
(43) Veröffentlichungstag der Anmeldung: **26.05.2010**
(21) Anmeldenummer: 08020400.1
(22) Anmeldetag: 24.11.2008
(51) Int. Cl.: H05K 7/20

(54) **Vorrichtung zur Befestigung einer elektronischen Baugruppe**

(71) Anmelder: Siemens Aktiengesellschaft, 80333 München (DE)
(72) Erfinder: Bergmann, Martin, 92253 Schnaittenbach (DE); Busch, Klaus, 92224 Amberg (DE); Fürholzer, Roland, 92224 Amberg (DE); Wiesner, Christoph, 92224 Amberg (DE)

(57) **Zusammenfassung**

Bei einer Vorrichtung (1) zur Befestigung einer elektronischen Baugruppe (2), umfassend eine sich längs erstreckende Schiene, ein erstes Befestigungsmittel zur Aufnahme von Haltemitteln (4a,4b) der Baugruppe (2), wird die Aufgabe eine Möglichkeit zur Temperierung der Baugruppe (2) zu schaffen dadurch gelöst, dass an der Schiene eine erste Anschlussstelle (5a) zur Aufnahme eines Mediums angeordnet ist, wobei das Medium für eine Temperierung der Baugruppe (2) verwendbar ist und über eine zweite Anschlussstelle (5b) wieder abfließen kann.

## Beschreibung

Die Erfindung betrifft eine Vorrichtung zur Befestigung einer elektronischen Baugruppe, umfassend eine sich längs erstreckende Schiene und ein erstes Befestigungsmittel zur Aufnahme von Haltemitteln der Baugruppe.

Eine derartige Vorrichtung wird bereits, beispielsweise in der Automatisierungstechnik, insbesondere in Schaltschränken, zum Befestigen von Baugruppen verwendet. Dabei ist die Schiene als eine sogenannte Hutprofilschiene ausgestaltet. Auf dieser Hutprofilschiene können Baugruppen angeordnet werden. Dazu werden sie mit einem Haltemittel, beispielsweise zuerst an einer oberen Kante der Hutprofilschiene eingehakt und dann mittels eines weiteren Haltemittels mit der unteren Kante der Hutprofilschiene verrastet und somit lösbar befestigt.

Aus der Patentschrift EP 0 740 499 B1 ist eine Befestigung einer Baugruppe an einer Hutschiene bereits bekannt. Gemäß der Offenbarung dieser Patentschrift ist vorgesehen, dass Hutschienen-Befestigungen der Baugruppe direkt an einem Kühlkörper der Baugruppe angebracht sind. Die Baugruppe kann somit also über den Kühlkörper an der Hutschiene befestigt werden. Ziel der Vorrichtung nach der EP 0 470 499 B1 ist es, eine mechanisch stabile Aufhängung, bei insbesondere massiven Ausführungen von Kühlkörpern und Baugruppen zu erreichen.

Bei heutigen Baugruppen bzw. Baugruppensystemen ist innerhalb der Baugruppen mit immer höheren Verlustleistungen zu rechnen. Um die Baugruppen, beispielsweise zu entwärmen, müssen zusätzliche Maßnahmen ergriffen werden. Ebenso ist es in manchen Fällen notwendig, die Baugruppen vor zu großer Kälte zu schützen. In den meisten Fällen muss jedoch eine Baugruppe gekühlt werden. Nachteilig an dem genannten Stand der Technik ist es, dass bei einer an der Vorrichtung befestigten Baugruppe, die Temperatur der Baugruppe nicht beeinflusst werden kann.

Es ist daher die Aufgabe der Erfindung eine Vorrichtung bereitzustellen, welche es ermöglicht die Baugruppe zu temperieren.

Die Aufgabe wird für die eingangs genannte Vorrichtung dadurch gelöst, dass an der Schiene eine erste Anschlussstelle zur Aufnahme eines Mediums angeordnet ist, wobei das Medium für eine Temperierung der Baugruppe verwendbar ist. Mit dem ersten Anschluss zur Aufnahme eines Mediums wird die Möglichkeit geschaffen, die beispielsweise als Profilschiene ausgestaltete Vorrichtung mit einem von extern zugeführten Medium zu temperieren, d.h. die Profilschiene kann sowohl durch das Medium gekühlt als auch durch das Medium erwärmt werden. Als Medien sind denkbar, ein gasförmiges Medium oder ein flüssiges Medium.

In einer bevorzugten Ausgestaltung ist eine zweite Anschlussstelle derart an der Schiene angeordnet, dass das Medium von der ersten zur zweiten Anschlussstelle führbar ist. Durch ein kontinuierliches Hindurchführen eines Mediums, beispielsweise durch eine als Profilschiene ausgestaltete Vorrichtung, wird die Temperierung der Baugruppe bzw. der Profilschiene dadurch begünstigt, dass eine konstante Zieltemperatur eingehalten werden kann.

In einer weiteren vorteilhaften Ausgestaltung ist zwischen der ersten Anschlussstelle und der zweiten Anschlussstelle ein Strömungskanal angeordnet. Mittels des Strömungskanals kann das Medium, welches entweder für eine Kühlung oder für eine Erwärmung sorgt, gezielt an die Stellen gebracht werden, welche einen erhöhten Kühlbedarf bzw. einen Heizbedarf haben.

In einer besonders optimierten Ausgestaltungsform der Vorrichtung ist der Strömungskanal im Befestigungsmittel der Schiene integriert. Das Befestigungsmittel stellt dabei beispielsweise einen Schenkel der Profilschiene dar, an diesen Schenkel wird die Baugruppe, vorzugsweise eingerastet, und der Schenkel kann vorzugsweise Kontakt zu einem in der Baugruppe integrierten Kühlkörper finden.

Weiterhin ist es von Vorteil wenn der Strömungskanal Austrittsöffnungen aufweist, welche derart angeordnet sind, dass das Medium zumindest teilweise in die Baugruppe strömt. Es ist mit dieser Ausgestaltung beispielsweise möglich über die erste Anschlussstelle ein Druckluftanschluss an die Profilschiene anzuschließen, wobei die Druckluft durch die Austrittsöffnungen, welche beispielsweise durch kleine Bohrungen im Vorderbereich der Profilschiene realisiert sind, ausströmt. Durch die ausströmende Druckluft ist eine Konvektion innerhalb der Baugruppe angeregt und die sich in der Baugruppe erwärmte Luft kann über Luftaustrittsöffnungen in der Baugruppe, beispielsweise nach oben entweichen.

In einer optimierten Ausgestaltung der Vorrichtung weist der Strömungskanal eine profilierte Kontur zur Vergrößerung einer mit dem Medium kontaktierten Fläche auf. Der Strömungskanal, welcher beispielsweise als eine durchgehende Bohrung in Längsrichtung der Schiene, innerhalb des unteren Befestigungsmittels der Profilschiene realisiert ist, kann im einfachsten Fall als eine runde Bohrung ausgestaltet werden. Diese runde Bohrung kann wiederum weiter durch eine oberflächenoptimierte Kontur erweitert werden. D.h. es wird beispielsweise eine Kontur in die Bohrung eingefräst, welche eine maximale Oberfläche zum Kontaktieren mit dem Medium bildet.

Weiterhin ist es vorteilhaft, dass die Schiene eine thermische Kontaktfläche aufweist, welche derart angeordnet ist, dass ein thermischer Ausgleich zwischen der Baugruppe und dem Medium möglich ist.

Weitere Vorteile und Ausgestaltungsmerkmale werden anhand der Zeichnung in einem Ausführungsbeispiel erläutert. Es zeigen:
- FIG 1: eine Vorrichtung zur Befestigung einer Baugruppe mit einem Wärmeregulator und
- FIG 2: diverse Konturformen und Ausprägungen für einen Strömungskanal.

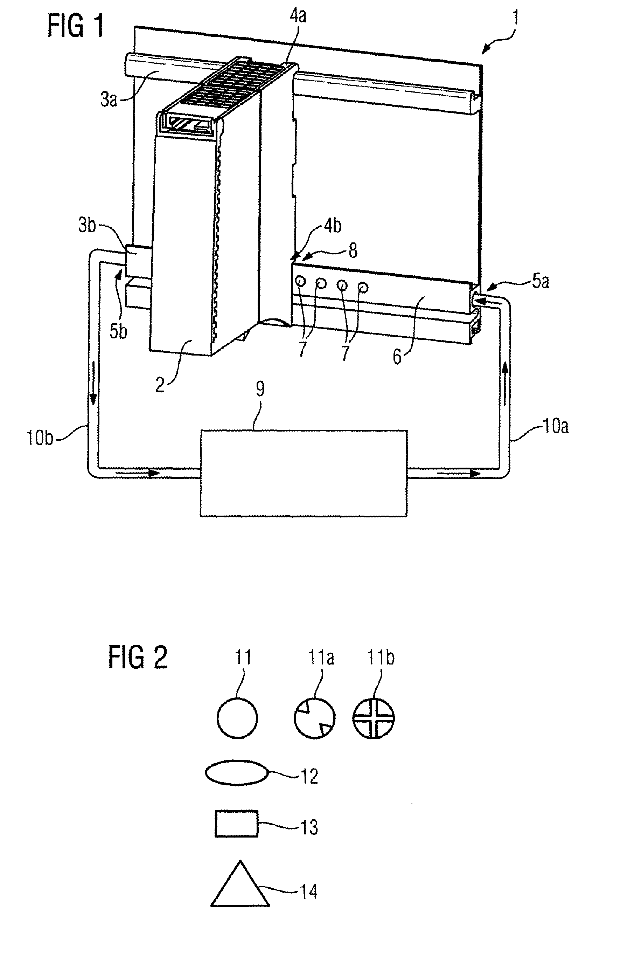

Gemäß FIG 1 ist eine Vorrichtung 1 zum Befestigen von Baugruppen dargestellt. Die Vorrichtung 1 umfasst eine sich längs erstreckende Schiene, ein erstes Befestigungsmittel 3a, ein zweites Befestigungsmittel 3b, eine erste Anschlussstelle 5a für ein Kühlmittel und eine zweite Anschlussstelle 5b wiederum für das Kühlmittel.

Eine Baugruppe 2 ist mit einem ersten Haltemittel 4a an dem ersten Befestigungsmittel 3a der Vorrichtung 1 befestigt und mit einem zweiten Haltemittel 4b analog zu dem oben gesagten an dem zweiten Befestigungsmittel 3b ebenfalls befestigt. Diese Befestigung wird üblicherweise durch Verrasthaken ausgestaltet und die Baugruppe 2 kann somit über das erste Befestigungsmittel 3a und das zweite Befestigungsmittel 3b auf die Vorrichtung, welche als eine Hutprofilschiene ausgestaltet ist, aufgerastet werden.

An die erste Anschlussstelle 5a der Profilschiene ist eine erste Kühlleitung 10a angeschlossen. Diese erste Kühlleitung 10a ist mit einem Wärmeregulator 9 verbunden. Die zweite Anschlussstelle 5b der Profilschiene ist über eine zweite Kühlleitung 10b mit dem Wärmeregulator 9 verbunden.

Die Verbindungsmöglichkeit der ersten Anschlussstelle 5a kann durch ein in die Bohrung der Anschlussstelle 5a eingebrachtes Gewinde realisiert werden. Die Kühlleitung 10a bzw. die Kühlleitung 10b weist dann ein entsprechendes Gegenstück zum Einschrauben der Kühlleitung 10a,10b in die erste bzw. zweite Anschlussstelle 5a,5b auf.

Der Wärmeregulator 9 ist als eine Wärmepumpe ausgestaltet und pumpt kontinuierlich ein Kühlmittel über die erste Kühlmittelleitung 10a in die erste Anschlussstelle 5a, dabei wird das Kühlmittel innerhalb des Strömungskanals 6 geführt.

Im Falle eines flüssigen Kühlmittels sind die in FIG 1 dargestellten Austrittsöffnungen 7 nicht vorhanden. Diese Austrittsöffnungen 7 sind für den Fall vorgesehen, dass Druckluft in den Strömungskanal 6 geschickt wird und die Druckluft über die Austrittsöffnungen 7 in die Baugruppe 2 zum Kühlen bzw. zum Anregen einer Konvektion strömen kann.

Die Baugruppe 2 steht mit einem nicht dargestellten Kühlkörper thermisch in guter Verbindung mit einer Kontaktfläche 8, welche auf der Profilschiene angeordnet ist. Für den Fall einer Entwärmung der Baugruppe kann ein Wärmestrom aus dem Kühlkörper in die Kontaktfläche 8 und somit in die gesamte Profilschiene fließen. Um diesen Wärmestrom möglichst zügig ableiten zu können, wird kontinuierlich das Kühlmittel über die Anschlussstelle 5a in den Strömungskanal 6 geführt, wobei es mit einer erhöhten Temperatur im Vergleich zu der Temperatur beim Eintritt in den Strömungskanal 6 über die zweite Anschlussstelle 5b verlässt und mit der zweiten Kühlleitung 10b dem Wärmeregulator 9 wiederum zugeführt wird. In diesem Wärmeregulator 9 wird das Kühlmittel erneut auf eine zum Kühlen notwendige niedrige Temperatur gebracht.

Gemäß FIG 2 sind verschiene Grundformen für eine Kontur, welche der Strömungskanal im Inneren aufweisen kann, dargestellt. Eine erste Kontur 11 ist kreisrund ausgestaltet, eine zweite Kontur 12 ist ellipsenförmig ausgestaltet, eine dritte Kontur 13 ist quadratisch bzw. rechteckig ausgestaltet und eine vierte Kontur 14 ist dreieckig ausgestaltet. Über die Wahl einer entsprechenden Kontur 11,12,13,14 kann eine Entwärmung bzw. eine Aufheizung der Baugruppe 2 optimiert werden.

Als weitere mögliche Ausprägung der kreisrunden ersten Kontur 11 ist eine erste Konturausprägung 11a abgebildet, welche sich dadurch auszeichnet, dass im Inneren der kreisrunden Kontur sich mit dem Strömungskanal längs erstreckende Keile angeordnet sind, als zweite Konturausprägungsform 11b wird eine kreisrunde Kontur mit ebenfalls im Inneren des Strömungskanals angeordneten Kreisviertelsegmenten vorgeschlagen, so dass für die Durchströmung des Mediums durch den Strömungskanal eine kreuzähnliche Durchtrittsöffnung übrig bleibt. Damit ist die Kontaktfläche zu dem Medium vergrößert.

Falls auf einer Profilschiene nur einzelne Baugruppen gekühlt werden müssen, da nur diese einzelnen Baugruppen sehr heiß werden, während benachbarte Baugruppen demgegenüber kühler sind, kann eine sogenannte "Heat Pipe" in die Kontur bzw. in den Strömungskanal eingesetzt werden. Ein Anschluss an eine externe Wärmeregulierung ist dann vorzugsweise nicht nötig. Die "Heat Pipe" sorgt für eine schnelle Verteilung der Wärme über die gesamte Profilschienenlänge, dadurch werden auftretende Hot Spots entschärft.

Im Regelfall befinden sich auf der Profilschiene 1 nicht nur ein, sondern mehrere Baugruppen nebeneinander. Es kommt vor, dass nicht alle Baugruppen heiß werden, sondern nur eine oder einige wenige. In diesem Fall ist es ausreichend, die entstehende Wärme auf die komplette Länge der Schiene und damit auf alle Baugruppen zu verteilen, so dass die zulässige Maximaltemperatur der heißen Baugruppe/-n unterschritten wird, während die benachbarten Baugruppen wärmer werden. Dabei ist jedoch darauf zu achten, dass die zulässigen Maximaltemperaturen der benachbarten Baugruppen nicht überschritten werden.

Diese Verteilung kann durch eine sogenannte Heat Pipe erfolgen. Das ist eine Art Rohr, das an beiden Enden geschlossen ist und einen geringen Wärmewiderstand hat. Auf diese Weise lässt sich Wärme sehr schnell ableiten. Vorteilhaft daran ist, dass die Heat Pipe an keine externe Wärmeregulierung angeschlossen werden muss.

## Patentansprüche

1. Vorrichtung (1) zur Befestigung einer elektronischen Baugruppe (2), umfassend eine sich längs erstreckende Schiene und ein erstes Befestigungsmittel (3a) zur Aufnahme von Haltemitteln (4a) der Baugruppe (2),
**dadurch gekennzeichnet, dass**
an der Schiene eine erste Anschlussstelle (5a) zur Aufnahme eines Mediums angeordnet ist, wobei das Medium für eine Temperierung der Baugruppe (2) verwendbar ist.

2. Vorrichtung (1) nach Anspruch 1,
wobei eine zweite Anschlussstelle (5b) derart an der Schiene angeordnet ist, dass das Medium von der ersten (5a) zur zweiten Anschlussstelle (5b) führbar ist.

3. Vorrichtung (1) nach Anspruch 1 oder 2,
wobei zwischen der ersten Anschlussstelle (5a) und der zweiten Anschlussstelle (5b) ein Strömungskanal angeordnet ist.

4. Vorrichtung (1) nach Anspruch 3,
wobei der Strömungskanal (6) im Befestigungsmittel (3a) integriert ist.

5. Vorrichtung (1) nach Anspruch 3 oder 4,
wobei der Strömungskanal (6) Austrittsöffnungen (7) aufweist, welche derart angeordnet sind, dass das Medium zumindest teilweise in die Baugruppe (2) strömt.

6. Vorrichtung (1) nach einem der Ansprüche 3 bis 5,
wobei der Strömungskanal (6) eine profilierte Kontur (11,12, 13,14) zur Vergrößerung einer mit dem Medium kontaktierten Fläche aufweist.

7. Vorrichtung (1) nach einem der Ansprüche 1 bis 6,
wobei die Schiene eine thermische Kontaktfläche (8) aufweist, welche derart angeordnet ist, dass ein thermischer Ausgleich zwischen der Baugruppe (2) und dem Medium möglich ist.
